Europäisches Patentamt

European Patent Office

Office européen des brevets

(11) Publication number: **0 427 200 A1**

## (12) EUROPEAN PATENT APPLICATION

(21) Application number: **90121217.5**

(22) Date of filing: **06.11.90**

(51) Int. Cl.⁵: **H01L 27/108**

The title of the invention has been amended (Guidelines for Examination in the EPO, A-III, 7.3).

(30) Priority: **06.11.89 JP 288416/89**

(43) Date of publication of application:
**15.05.91 Bulletin 91/20**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Kitamura, Mamoru, c/o NEC Corporation**
**7-1, Shiba 5-chome**
**Minato-ku, Tokyo(JP)**

(74) Representative: **Glawe, Delfs, Moll & Partner**
**Patentanwälte**
**Postfach 26 01 62**
**W-8000 München 26(DE)**

(54) Semiconductor memory cell with improved stacked capacitor and process of fabrication thereof.

(57) A semiconductor memory cell is fabricated on a semicoductor substrate (21) and comprises a switching transistor (23) having a source and drain regions (23a/23b) and covered with a lower inter-level insulating film (25), and a stacked storage capacitor (24) coupled through a contact hole (25a) formed in the lower inter-level insulating film to one of the source and drain regions and having a lower electrode (24a) provided on the lower inter-level insulating film and having a side surface portion, a dielectric film (24b) covering the lower electrode and an upper electrode (24c) covering the dielectric film, in which at least one cave (24ac) is made on the side surface portion so that the amount of surface area and, accordingly, the amount of electric charges accumulated in the stacked storage capacitor are increased even if the stacked storage capacitor occupies a relatively small amount of the real estate.

FIG.4

EP 0 427 200 A1

# SEMICONDUCTOR MEMORY CELL WITH IMPROVED STACKED STORAGE CAPACITOR AND PROCESS OF FABRICATION THEREOF

## FIELD OF THE INVENTION

This invention relates to a semiconductor memory cell and, more particularly, to the configuration of a stacked storage capacitor incorporated in a dynamic random access memory cell.

## DESCRIPTION OF THE RELATED ART

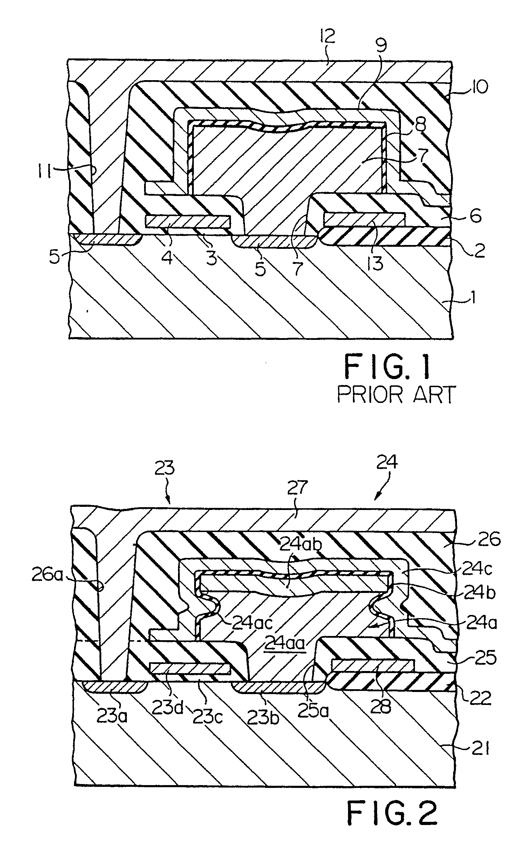

A typical example of the dynamic random access memory cell is shown in Fig. 1 and fabricated on a p-type silicon substrate 1 through the following process sequence. A thick field oxide film 2 is grown on the surface of the silicon substrate 1 and defines an active area. A thin gate oxide film 3 is thermally grown on the active area, and a first polysilicon film is deposited on the entire surface. The first polysilicon film is patterned to form a word line 4 on the thin gate oxide film 3 through a lithography process, and the word line 4 thus patterned provides a mask layer for an ion implantation stage. Phosphorus atoms are ion-implanted into the active area, and heavily-doped n-type source/drain regions 5 are formed at spacing. The source/drain regions 5, the thin gate oxide film 3 and the word line 4 form in combination a switching transistor.

The resultant structure of this stage is, then, covered with an inter-level insulating film 6, and a contact hole 7 is formed in the inter-level insulating film 6 in such a manner as to allow the source/drain region 5 to be exposed. A second polysilicon film is deposited on the entire surface of the structure and, then, selectively etched away so as to form a lower electrode 7 of a storage capacitor. Since the contact hole 5 was formed, a shallow recess unintentionally takes place during the deposition of the second polysilicon film, and, accordingly, the top surface of the lower electrode 7 is slightly deformed.

The entire surface of the lower electrode 7 is thermally oxidized, and a thin dielectric film 8 is produced in the surface portion of the lower electrode 7. A third polysilicon film is deposited on the entire surface of the structure and, then, patterned to form an upper electrode 9 of the storage capacitor.

After formation of an inter-level insulating film 10, a contact hole 11 is formed and reaches the surface of the other source/drain region 5. Aluminum is deposited on the entire surface of the structure and, then, patterned to form a digit line 12. Reference numeral 13 designates another word line extending on the thick field oxide film

A problem is encountered in the prior art semiconductor memory cell in that electric charges accumulated in the stacked capacitor is not enough to memorize a piece of data informtion. This is because of the fact that the total amount of the surface area of the lower electrode 7 tends to be decreased together with the dimensions of the semi-conductor memory cell. When the integration density of the dynamic random access memory device is increased, this tendency is very serious.

## SUMMARY OF THE INVENTION

It is therefore an important object of the present invention to provide a semiconductor memory cell which has a stacked storage capacitor with a large amount of surface area.

To accomplish these objects, the present invention proposes to intentionally deform a side surface of the lower electrode of a stacked storage capacitor.

In accordance with one aspect of the present invention, there is provided a semiconductor memory cell fabricated on a semiconductor substrate, comprising: a) a switching transistor having source and drain regions and covered with a lower inter-level insulating film; and b) a stacked storage capacitor coupled through a contact hole formed in the lower inter-level insulating film to one of the source and drain regions and having a lower electrode provided on the lower inter-level insulating film and having a side surface portion, a dielectric film covering the lower electrode and an upper electrode covering the dielectric film, in which at least one cave is made on the side surface portion, and in which the dielectric film and the upper electrode trace a surface configuration of the lower electrode.

In accordance with another aspect of the present invention, there is provided a process for fabricating a semiconductor memory cell, comprising the steps of: a) preparing a semiconductor substrate; b) producing a switching transistor on the semiconductor substrate, the switching transistor having source and drain regions; c) covering the switching transistor with a lower inter-level insulating film, the lower inter-level insulating film having a contact hole exposing one of the source and drain regions; d) forming a lower electrode of a stacked storage capacitor on the lower inter-level insulating film, the lower electrode being held in contact with aforesaid one of the source and drain regions through the contact hole; and e) forming a thin dielectric film and an upper electrode so as to complete the stacked storage capacitor, in which the step d) comprises the sub-steps of d-1) forming a semicon ductor material block having a heavily doped portion at a predetermined depth from a top surface of the semiconductor material block, d-2) exposing the heavily doped portion to a side surface of the semiconductor material block, and d3) etching the semiconductor material block, the heavily doped portion being rapidly etched so that a cave is made on a side portion of the semiconductor material block.

## BRIEF DESCRIPTION OF THE DRAWINGS

The features and advantages of a semiconductor memory cell and a process of fabrication thereof according to the present invention will be more clearly understood from the following description taken in conjunction with the accompanying drawings in which:

Fig. 1 is a cross sectional view showing the structure of the prior art dynamic-type random access memory cell;

Fig. 2 is a cross sectional view showing the structure of a dynamic-type random access memory cell according to the present invention;

Figs. 3A to 3D are cross sectional views showing a process sequence for fabricating the dynamic-type random access memory cell shown in Fig. 2 in accordance with the present invention;

Fig. 4 is a cross sectional view showing the structure of another dynamic random access memory cell according to the present invention;

Figs. 5A to 5D are cross sectional views showing an essential part of a process sequence for fabricating the random access memory cell shown in Figs 4;

Fig. 6 is a cross sectional view showing the structure of still another random access memory cell according to the present invention; and

Fig. 7 is a graph showing an impurity atom concentration in terms of depth from the surface of a lower electrode incorporated in the random access memory cell shown in Fig. 6.

## DESCRIPTION OF THE PREFERRED EMBODIMENTS

First Embodiment

Referring first to Fig. 2 of the drawings, a dynamic random access memory cell is fabricated on a p-type silicon substrate 21 partially covered with a thick field oxide film 22 and comprises a switching transistor 23 and a stacked storage capacitor 24. The switching transistor 23 comprises two heavily-doped n-type source/drain regions 23a and 23b formed in the silicon substrate 21 at spacing, a thin gate oxide film 23c provided over that area between the two source/drain regions 23a and 23b, and a word line 23d formed on the thin gate oxide film 23c. The switching transistor 23 thus formed allows a conductive channel to take place between the source/drain regions 23a and 23b upon application of an active high voltage signal to the word line 23d.

The stacked storage capacitor 24 is coupled to one of the source/drain regions 23a and 23b through a contact hole 25a formed in a lower inter-level insulating film 25. The stacked storage capacitor 24 comprises a lower electrode structure 24a, a thin dielectric film 24b covering the entire surface of the lower electrode structure 24a, and an upper electrode 24c formed on the thin dielectric film 24b and confronted with the lower electrode structure 24a. The lower electrode structure 24a is formed by a lower polysilicon strip 24aa and an upper polysilicon strip 24ab, and the lower polysilicon strip 24aa is constricted so that a cave 24ac is intentionally made on the side portion thereof. The cave 24ac makes a loop along the side surface of the lower polysilicon strip 24aa, and the thin dielectric film 24ac and the upper electrode 24c trace the surface configuration of the lower electrode 24a, and, for this reason, the amount of surface area confronted with the upper electrode 24c is increased. In general, the amount of electric charges accumulated in a capacitor is proportional to the amount of surface area confronted with the opposite electrode. Since the cave 24ac increases the amount of the surface area, the amount of electric charges accumulated is hardly decreased even though the stacked storage capacitor 24 occupies a relatively smaller amount of the real estate of the silicon substrate 21 than the prior art random access memory cell.

The stacked storage capacitor 24 is covered with an upper inter-level insulating film 26, and a bit line 27 penetrates a contact hole 26a so as to reach the other source/drain region 23a. Reference numeral 28 designates another word line extending on the thick field oxide film 22.

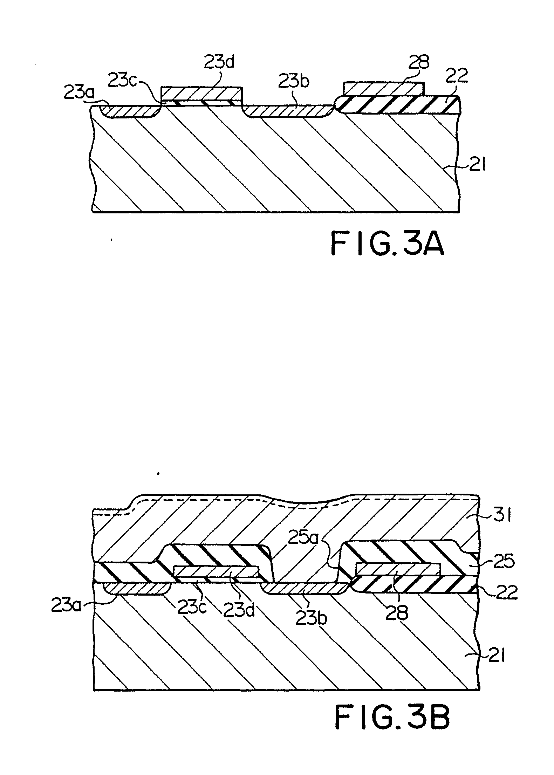

Description is made on a process of fabricating the random access memory cell shown in Fig. 2. The process sequence starts with preparation of the p-type silicon substrate 21. The thick field oxide film 22 is thermally grown to a thickness of about 500 nanometer through a localized oxidation of silicon technique, and a thin silicon oxide film is thermally grown to a thickness of 20 nanometer. A first polysilicon film is deposited on the entire surface of the structure to a thickness of about 400 nanometer and is, then, partially etched away through a lithographic process so that the word lines 23d and 28 are formed on the thin silicon oxide film and the thick field oxide film 22, respectively. Using the word lines 23d as a mask layer, phosphorus atoms are ion-implanted into the silicon substrate 21, and an appropriate annealing is carried out so that the heavily doped n-type source and drain regions 23a and 23b are formed in the surface portion of the silicon substrate 21. The thin silicon oxide film is etched away except for the silicon oxide film beneath the word line 23d, and, accordingly, the thin gate oxide film 23c is formed over than area between the source and drain regions 23a and 23b. The resultant structure of this stage is shown in Fig. 3A.

The lower inter-level insulating film 25 is deposited on the entire surface of the structure, and a photo-mask layer (not shown) is applied on the lower inter-level insulating film 25. The lower inter-level insulating film 25 is partially etched away, and a contact hole 25a is formed in the lower inter-level insulating film, exposing one of the source/drain regions 23b. A second polysilicon film 31 is, then, deposited on the entire surface of the structure to a thickness of about 900 nanometer and is held in contact with the source/drain region 23b through the contact hole 25a. Phosphorus atoms are ion-implanted into the surface portion of the second polysilicon film 31 at dose of $1 \times 10^{15}$ atoms /cm² under an accelerating energy of about 400 KeV, and, for this reason, the surface portion of the second polysilicon film 31 is increased in the impurity atom concentration. The surface portion thus increased in the phosphorus atom concentration serves as a heavily doped portion in this instance. The resultant structure of this stage is illustrated in Fig. 3B.

A third polysilicon film is deposited on the entire surface of the structure to a thickness of about 100 nanometer, and the second polysilicon film 31 is overlain by the third polysilicon film. In this instance, the second and third polysilicon films form in combination a semiconductor material block.

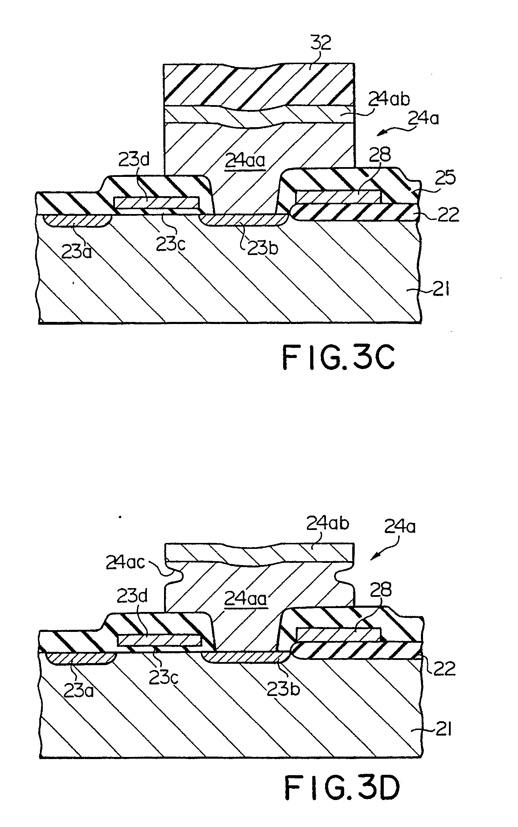

A photo-resist solution is spun onto the entire sur face to form a photo-resist film, and the photo-resist film is patterned to form a photo mask 32. Using the photo mask 32, the second and third polysilicon films are anisotropically etched away, and the lower and upper polysilicon strips 24aa and 24ab are formed on the lower inter-level insulating film 25 as shown in Fig. 3C. When the lower and upper polysilicon strips 24aa and 24ab are formed, the surface portion or the heavily doped portion is exposed to the side surface of the composite polysilicon structure or the semiconductor material block.

Subsequently, the lower and upper polysilicon strips 24aa and 24ab are subjected to an isotropic etching. Since the etching rate is proportional to the impurity atom concentration, the cave 24ac takes place around the lower polysilicon strip 24aa. The location of the cave 24ac is dependent on the projected range in the ion implantation into the surface portion of the second polysilicon film 31, because the maximum impurity atom concentration takes place at the projected range of the ion implantation. After the formation of the cave 24ac, the photo mask 32 is stripped off, and the lower electrode 24a is completed as shown in Fig. 3D.

The structure shown in Fig. 3D is placed in an oxidizing ambience, and the thin dielectric film 24b is grown on the entire surface of the lower electrode 24a. While the surface portion of the lower electrode 24a is oxidized, the phosphorus atoms in the surface portion of the lower polysilicon strip 24aa are diffused throughout the lower electrode 24a, and, for this reason, sufficient conductivity is imparted to the lower electrode 24a.

After the formation of the thin dielectric film 24b, a fourth polysilicon film is deposited on the entire surface of the structure, and the fourth polysilicon film is patterned so that the upper electrode 24c is formed on the thin dielectric film 24b. The upper inter-level insulating film 26 is deposited on the entire surface, and the contact hole 26a is formed in the lower and upper inter-level insulating films 25 and 26. An aluminum or aluminum-alloy film is deposited on the entire surface and etched to form the digit line 27. The structure shown in Fig. 2 is, thus, fabricated on the silicon substrate 21.

In this process sequence, the second and third poly-silicon films are concurrently patterned. However, the second and third polysilicon films may be individually patterned in another process sequence.

Second Embodiment

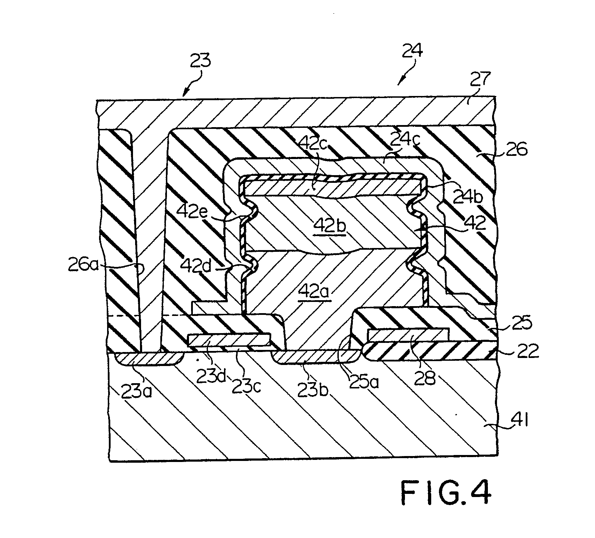

Turning to Fig. 4 of the drawings, another dynamic type random access memory cell is fabricated on a p-type silicon substrate 41. The structure of the dynamic type random access memory device shown in Fig. 4 is similar to that of the dynamic type random access memory cell shown in Fig. 2 except for a lower electrode 42, and, for this reason, corresponding films and regions are designated by the same reference numerals as those used in Fig. 2 withou any detailed description. The lower electrode 42 is constituted by three polysilicon strips 42a, 42b and 42c, i.e. the lower polysilicon strip 42a, the interemediate polysilicon strip 42b and the upper polysilicon strip 42c, and caves 42d and 42e are formed in the lowr and intermediate polysilicon strips 42a and 42b. The dielectric film 24b and the upper electrode 24c trance the surface configuration of the lower electrode 42, and, for this reason, the amount of surface area of the lower electrode 42 confronted with the upper electrode 24c is not so decreased even if the storage capacitor occupies a smaller amount of real estate of the silicon substrate 21 than the prior art random access memory cell.

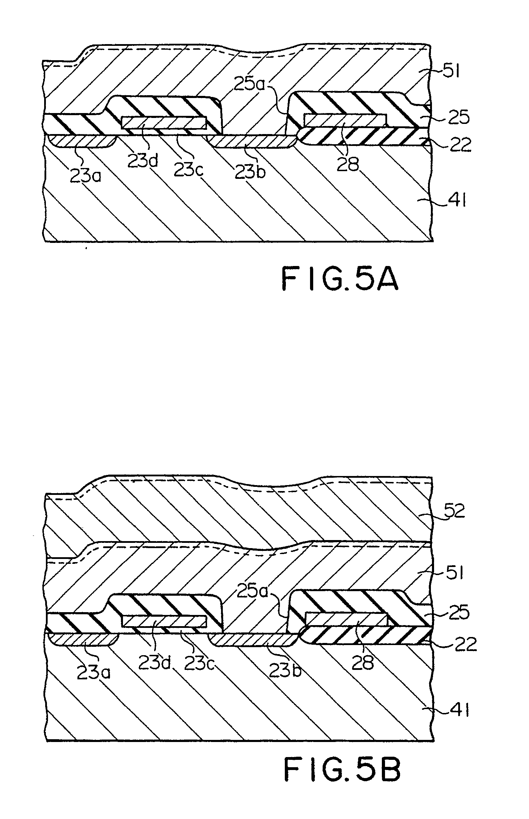

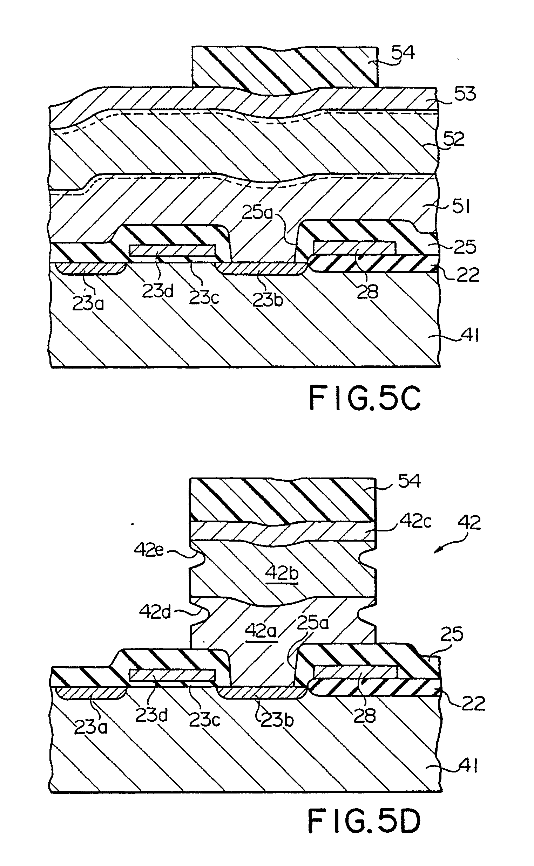

The lower electrode 42 is produced through a process sequence shown in Figs. 5A to 5D. After the contact hole is formed in the lower inter-level insulating film 25, a first polysilicon film 51 is deposited on the entire surface, adn phosphorus atoms are ion implanted into the first polysilicon film 51 at a predetermined depth as shown in Fig. 5A. A second polysilicon film 52 is deposited on the first polysilicon film 51, and the deposition is followed by the ion-implantation of phosphorus atoms at a predetermined depth again as shown in Fig. 5B. The second polysilicon film 52 is covered with a third polysilicon film 53 through the chemical vapor deposition, but no ion implantation is carried out for the third polysilicon film 53.

A photo-resist solution is spun onto the third polysilicon film 53, and the photo-resist film is patterned to form a photo mask 54. The first to third polysilicon films 51 to 53 are anisotropically etched way, and the lower, intermediate and upper polysilicon strips are stacked over the lower inter-level insulating film 25. The heavily doped portions with phosphorus atoms are exposed to the respective side surfaces of the lower and intermediate polysilicon strips 42a and 42b. The resultant structure is subjected to an isotropic side surface portions of the lower and intermediate polysilicon strips 42a and 42b as shown in Fig. 5D. The caves 42d and 42e make loops, respectively.

In this instance, the lower, intermediate and upper polysilicon strips 42a, 42b and 42c form in combination a semiconductor material block, and the portions heavily doped with phosphorus atoms serves as heavily doped portions. The photo mask 54 is then stipped off, and the thin dielectric film 24b and the upper electrode 24c are formed in a similar manner to those of the first embodiment.

In another implementation, more than two caves may be formed in a multiple-level lower electrode structure.

Third Embodiment

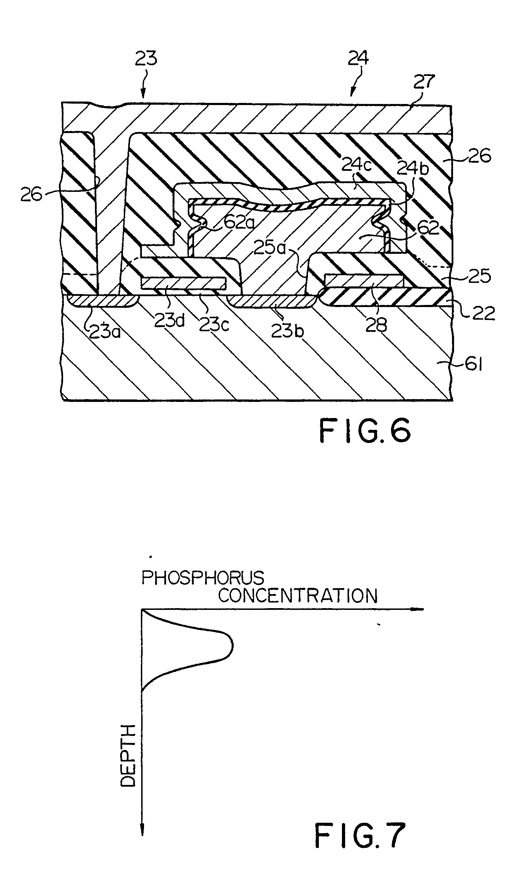

Turning to Fig. 6 of the drawings, still another dynamic-type random access memory cell is fabricated on a p-type silicon substrate. The dynamic-type random access memory cell shown in Fig. 6 is similar to the first embodiment except for a lower electrode 62, and, for this reason, corresponding films and regions are designated by the same reference numerals as the first embodiment without any detailed description. The lower electrode 62 of the storage capacitor 24 is implemented by a single polysilcon strip, and a cave 62a is made on the side surface portion of the lower polysilicon strip. In order to produce the cave 62a in the single polysilicon strip, phosphorus atoms are introduced deeper than the first polysilicon film 31, and acceleration energy of the ion implantation may be larger than that of the first embodiment. The profile of the phosphorus atom concentration is shown in Fig. 7, and the cave 62a has a cross section similar to the profile because the etching rate of the isotropic etching is increased together with the phosphorus atom concentration. A process sequence for formation of the lower electrode is similar to an initial stage of the formation of the lower electrode 24a.

Although particular embodiments of the present invention have been shown and described, it will be obvious to those skilled in the art that various changes and modifications may be made without departing from the spirit and scope of the present invention. For example, the thin dielectric film 24ac is implemented by a single silicon oxide film in the embodiment described hereinbefore. However, the thin dielectrice film may be of a composite film structure having a silicon oxide film and a silicon nitride film, by way of example. Moreover, the dopant may be another impurity atom.

## Claims

1. A semiconductor memory cell fabricated on a semiconductor substrate (21), comprising: a) a switching transistor (23) having source and drain regions (23a/23b) and covered with a lower inter-level insulating film (25); and b) a stacked storage capacitor (24) coupled through a contact hole (25a) formed in said lower inter-level insulating film to one of said source and drain regions and having a lower electrode (24a) provided on said lower inter-level insulating film and having a side surface portion, a dielectric film (24b) covering said lower electrode and an upper electrode (24c) covering said dielectric film, characterized in that at least one cave (24ca) is made on said side surface portion, and in that said dielectric film and said upper electrode trace a surface configuration of said lower electrode.

2. A process for fabricating a semiconductor memory cell, comprising the steps of: a) preparing a semiconductor substrate (21); b) producing a switching transistor having source and drain regions (23a/23b); c) covering said switching transistor with a lower inter-level insulating film (25), said lower inter-level insulating film having a contact hole (25a) exposing one of said source and drain regions; d) forming a lower electrode (24a) of a stacked storage capacitor (24) on said lower inter-level insulating film, said lower electrode being held in contact with said one of said source and drain regions through said contact hole; and e) forming a thin dielectric film (24b) and an upper electrode (24c) so as to complete said stacked storage capacitor, characterized in that said step d) comprises the sub-steps of d-1) forming a semiconductor material block having a heavily doped portion at a predetermined depth from a top surface of said semiconductor material block, d-2) exposing said heavily doped portion to a side surface of said semiconductor material block, and d-3) etching said semiconductor material block, said heavily doped portion being rapidly etched so that a cabe (24ca) is made on a side portion of said semiconductor material block.

FIG. 1
PRIOR ART

FIG. 2

23a  23c  23d  28  22  21

FIG.3A

23a  25a  25  22  28  23c  23d  23b  21  31

FIG.3B

FIG.3C

FIG.3D

FIG.4

FIG.5A

FIG.5B

11

FIG.5C

FIG.5D

FIG.6

PHOSPHORUS
CONCENTRATION

DEPTH

FIG.7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | PATENT ABSTRACTS OF JAPAN, vol. 14, no. 151 (E-906)[4094], 22nd March 1990; & JP-A-2 010 762 (MITSUBISHI ELECTRIC CORP.) 16-01-1990 – – – | 1,2 | H 01 L 27/108 |
| X | PATENT ABSTRACTS OF JAPAN, vol. 13, no. 155 (E-743), 14th April 1989; & JP-A-63 313 854 (FUJITSU LTD) 21-12-1988 – – – | 1,2 | |
| A | PATENT ABSTRACTS OF JAPAN, vol. 9, no. 118 (E-316)[1841], 23rd May 1985; & JP-A-60 009 154 (HITACHI) 18-01-1985 – – – – – | 1,2 | |

| | |
|---|---|
| | TECHNICAL FIELDS SEARCHED (Int. Cl.5) |
| | H 01 L |

The present search report has been drawn up for all claims

| Place of search | Date of completion of search | Examiner |
|---|---|---|
| The Hague | 20 December 90 | SINEMUS M. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

-----------------------------------------------------------

& : member of the same patent family, corresponding document